Europäisches Patentamt

European Patent Office

Office européen des brevets

(19)

(11) Publication number: **0 029 296**
**B1**

(12) **EUROPEAN PATENT SPECIFICATION**

(45) Date of publication of patent specification: **16.04.86**

(21) Application number: **80303575.7**

(22) Date of filing: **10.10.80**

(51) Int. Cl.⁴: **H 03 K 17/64,** H 01 F 7/18, H 02 P 3/04

(54) Internal combustion engine spark ignition system.

(30) Priority: **24.10.79 GB 7936860**

(43) Date of publication of application:
**27.05.81 Bulletin 81/21**

(45) Publication of the grant of the patent:
**16.04.86 Bulletin 86/16**

(84) Designated Contracting States:
**DE FR GB IT NL**

(56) References cited:
**DD-A- 140 374**
**US-A-3 143 668**

**IBM TECHNICAL DISCLOSURE BULLETIN, Vol. 16, No. 10, March 1974 New York L. WALLACE "Driver Circuit" pages 3182 and 3183**

**IBM TECHNICAL DISCLOSURE BULLETIN, Vol. 20, No. 8, January 1978 New York J.E. BATESON et al. "Pedestal Driver for Inductive Loads" pages 2948 to 2951**

(73) Proprietor: **LUCAS INDUSTRIES public limited company**
**Great King Street**
**Birmingham, B19 2XF West Midlands (GB)**

(72) Inventor: **Woodhouse, Richard Graham**
**225 Baldwins Lane**
**Hall Green Birmingham B28 OPZ. (GB)**

(74) Representative: **Prutton, Roger et al**
**Marks & Clerk Alpha Tower Suffolk Street Queensway**
**Birmingham B1 1TT (GB)**

Courier Press, Leamington Spa, England.

# Description

This invention relates to an internal combustion engine ignition system incorporating a plurality of ignition coils.

Electronic spark ignition systems for internal combustion engines have already been proposed in which distribution as well as spark generation is controlled electronically i.e., there are two or more ignition coils which are separately energised, and each drives its own spark circuit. With such an arrangement each coil primary is in series with an associated one of a plurality if output transistors. Each output transistor in the system needs to be capable of withstanding a high voltage, because of the high voltage transient which is created in a coil type spark ignition system when the transistor is switched off. High voltage transistors are expensive and the object of the present invention is to enable the number of high voltage transistors required to be reduced.

IBM Technical Disclosure Bulletin Volume 16 No. 10 of March 1974 discloses a circuit which is specifically intended for driving relays or solenoids. In this prior arrangement a transistor common to the two (or more) solenoids is energised initially to provide a relatively short duration "pick" pulse, whereafter current in the solenoids is controlled by a resistor. Current in each coil is terminated by turning off the appropriate one of two (or more) transistors, which must both be high voltage transistors if they are to survive the switch off transients. It is usual in solenoid control circuits to provide diode "freewheel" paths for the solenoids to avoid the need for high voltage transistors.

This prior proposal does not meet the requirements for a multi coil ignition set forth above.

In accordance with the invention there is provided an internal combustion engine spark ignition system including a plurality of ignition coils in which current flow is established and then interrupted to create sparks, a plurality of first transistors having collector-emitter paths connecting one end of respective ones of the coils to one side of a supply, the other ends of said coils being connected to a common point, a high-voltage transistor having its collector-emitter path connecting said common point to the other side of the supply, an input terminal connected to the base of said voltage transistor so that pulses applied to said input terminal render said high voltage transistor conductive for the duration of each such pulse, and a selection circuit connected to said input terminal and having a plurality of outputs connected to the bases of respective ones of the first transistors, said selection circuit operating to render the first transistors conductive in turn for periods commencing and terminating with the arrival of successive pulses at the input terminal, whereby interruption of current flow in the coils is effected by turning off the high voltage transistor at the end of each pulse.

In the accompanying drawings,

Figure 1 is a circuit diagram of a simple example of the invention;

Figure 2 is a graph showing waveforms at various points in Figure 1;

Figure 3 is a circuit diagram of another example of the invention, and

Figure 4 is a graph showing the current in one of the loads in Figure 3.

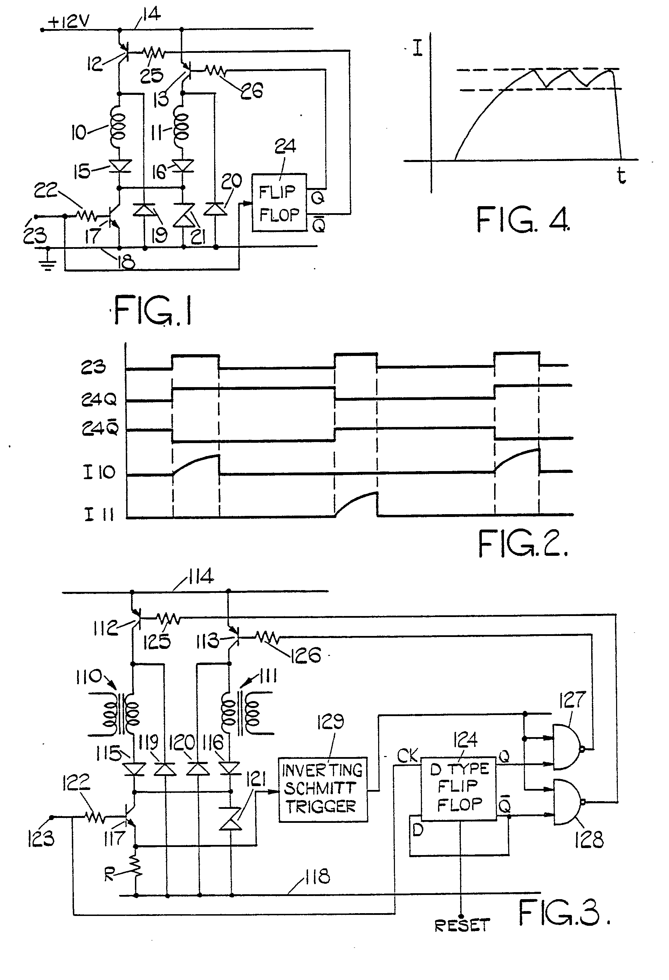

Referring firstly to Figure 1, the circuit shown includes two inductive loads 10, 11. One of loads 10 is connected to the collector of a low-voltage pnp transistor 12 and the load 11 is similarly connected to the collector of a low-voltage pnp transistor 13. The emitters of transistors 12 and 13 are connected to a 12V rail 14. The other end of each load 10, 11 is connected by an associated one of two diodes 15, 16 to a common point at the collector of a high-voltage npn transistor 17, the emitter of which is connected to an earth rail 18. The collectors of transistor 12, 13 are connected to the cathodes of two diodes 19, 20, the anodes of which are connected to the earth rail 18 and a zener diode 21 is connected between the collector of the transistor 17 and the earth rail 18.

The base of the transistor 17 is connected by a resistor 22 to an input terminal 23 which is also connected to the input of a standard flip-flop circuit 24. The Q and $\overline{Q}$ outputs of which are connected by respective resistors 25, 26 to the bases of the transistors 12, 13.

In use, the signal applied to the input terminal 23 is as shown in the upper line in Figure 2, i.e., terminal 23 repeatedly receives positive going pulses. Such pulses both clock the flip-flop circuit 24 and turn on the transistor 17. As will be appreciated from Figure 2 one or other of the transistors 12, 13 is on at all times, but transistor 17 is on only for the duration of the input pulses. Since the appropriate one of the transistors 12, 13 remains on after the transistor 17 turns off, transistors 12, 13 are never subjected to high voltage transients.

Turning now to Figure 3, there is shown another example of the invention including two independent ignition transformers 110, 111, the primary windings of which represent the inductive loads corresponding to loads 10 and 11 in Figure 1. Low voltage transistors 112 and 113 are arranged with the collector emitter paths connecting these primary windings at one end to a positive supply rail 114. Diodes 115, 116 connect the other ends of the primary windings to the collector of a common high voltage transistor 117, the emitter of which is granted to the ground 118 via a current sensing resistor R. Diodes 119 and 120 and a zener diode 121 are arranged like the corresponding components 19, 20 and 21 in Figure 1.

The input terminal 123 is connected by a resistor 122 to the base of transistor 117 and is also connected to the CLOCK terminal of a D-type flip-flop circuit 124, the D input of which is connected to its $\overline{Q}$ output. The Q and $\overline{Q}$ outputs of circuit 124 are connected to two NAND gates 127 and 128 which also have inputs connected to the output of an inverting Schmitt-trigger circuit 129 having its input connected to the emitter of the transistor 117.

In operation, the circuit of Figure 3 is much like that in Figure 1 except that the Schmitt-trigger circuit provides additional control over the transistors 112 and 113 to control the current in the associated primary windings. Thus, when for example, transistor 117 turns on and transistor 112 is conductive the current in the primary winding of transformer 110 will start to increase normally, but when the current in resistor R reaches a level such that the voltage across R exceeds the upper threshold voltage of the Schmitt-trigger circuit 129 the output of the circuit 129 will go low, thereby causing the output of gate 128 to go high, and thereby turning off the transistor 112. The maximum voltage across the transistor 112 is limited by current recirculating in diode 119 and the current in the primary winding of transformer 110 decays until the voltage across resistor R falls below the lower threshold voltage of circuit 129 so that the output of this circuit goes high again. The gate 128 output then goes low again turning on transistor 112 and causing the current in the primary winding to start to rise again. When transistor 117 turns off the coil current is interrupted as before and the rapid change in current induces a spark in the normal manner. During current regulation the rate of change of the current is not high enough for a spark to be induced.

## Claims

1. An internal combustion engine spark ignition system including a plurality of ignition coils (10, 11) in which current flow is established and then interrupted to create sparks, a plurality of first transistors (12, 13) having collector-emitter paths connecting one end of respective ones of the coils to one side (14) of a supply, the other ends of said coils being connected to a common point, a high-voltage transistor (17) having its collector-emitter path connecting said common point to the other side (18) of the supply, an input terminal (23) connected to the base of said high voltage transistor so that pulses applied to said input terminal render said high voltage transistor conductive for the duration of each such pulse, akd a selection circuit (24) connected to said input terminal and having a plurality of outputs connected to the bases of respective ones of the first transistors (12, 13), said selection circuit operating to render the first transistors conductive in turn for periods commencing and terminating with the arrival of successive pulses at the input terminal, whereby interruption of current flow in the coils is effected by turning off of the high voltage transistor at the end of each pulse.

2. A system as claimed in claim 1 further comprising a plurality of diodes (15, 16) connecting said other end of respective ones of the coils to said common point.

3. A system as claimed in claim 2 further comprising a plurality of further diodes (19, 20) connecting said one end of respective ones of the coils to said other terminal (18).

4. A system as claimed in claim 1, 2 or 3 further comprising a zener diode (21) connecting said common points to said other terminal (18).

5. A system as claimed in claim 1 in which said means for selectively turning on said low voltage transistors (12, 13) comprises a flip-flop circuit (24) connected to be triggered by a signal at an input terminal (23) which also controls said high voltage transistor (17).

6. A system as claimed in claim 3 further comprising a resistor (R) in series with said high voltage transistor (117), and current control means (129) connected to said resistor (R) and to said low voltage transistors (112, 113) and acting to switch on and off whichever of the low voltage transistors is on at any given time in accordance with the voltage across said resistor to regulate the current in the associated load.

7. A system as claimed in claim 6 in which the means for selectively turning on the low voltage transistors is a flip-flop circuit (124) connected to be triggered by a signal at an input terminal (123), and said current control means comprises a Schmitt trigger circuit (129) connected to said resistor (R) and a pair of gates (127, 128) connected to said Schmitt-trigger circuit and to respective outputs of the flip-flop circuit and controlling the respective low voltage transistors (113, 112).

## Patentansprüche

1. Zündsystem für Brennkraftmaschinen mit einer Mehrzahl von Zündspulen (10, 11), in denen Stromfluß aufgebaut und dann zum Erzeugen von Funken unterbrochen wird, einer Mehrzahl von ersten Transistoren (12, 13) mit Kollektor-Emitter-Bahnen, die ein Ende der betreffenden der Spulen mit einem Ende (14) einer Versorgung verbinden, wobei die anderen Enden der Spulen an einem gemeinsamen Punkt verbunden sind, einem Hochspannungtransistor (17) mit einer Kollektor-Emitter-Bahn, die den gemeinsamen Punkt mit der anderen Seite (18) der Versorgung verbindet, einem mit der Basis des Hochspannungstransistors so verbundenen Eingangsanschluß (23), daß an den Einangsanschluß angelegte Impulse während der Dauer eines solchen Impulses den Hochspannungstransistor leitend machen, einem mit dem Eingangsanschluß verbundenen Wählstromkreis (24), der eine Mehrzahl von mit den Basen der betreffenden der ersten Transistoren (12, 13) verbundenen Ausgänge aufweist, wobei der Wählstromkreis bewirkt, daß die ersten Transistoren abwechselnd für Perioden beginnend und endend mit der Ankunft aufeinanderfolgender Impulse am Eingangsanschluß leitend gemacht werden, wobei die Unterbrechung des Stromflusses in den Spulen durch Abschalten des Hochspannungstransistors am Ende eines jeden Impulses bewirkt wird.

2. System nach Anspruch 1, weiterhin mit einer Mehrzahl von Dioden (15, 16), die das andere Ende der betreffenden der Spulen mit dem gemeinsamen Punkt verbinden.

3. System nach Anspruch 2, weiterhin mit einer Mehrzahl von weiteren Dioden (19, 20), die das eine Ende der betreffenden der Spulen mit dem anderen Anschluß (18) verbinden.

4. System nach Anspruch 1, 2 oder 3, weiterhin mit einer Zener-Diode (21), die den gemeinsamen Punkt mit dem anderen Anschluß (18) verbindet.

5. System nach Anspruch 1, in dem die Vorrichtung zum wahlweisen Einschalten der Niederspannungstransistoren (12, 13) einen so angeschlossenen Flip-Flop-Schaltkreis (24) aufweist, daß er durch ein Signal an einem Eingangsanschluß (23), das auch den Hochspannungstransistor (17) steuert, ausgelöst wird.

6. System nach Anspruch 3, weiterhin mit einem Widerstand (R) in Reihen mit dem Hochspannungstransistor (117) und einer Stromsteuereinrichtung (129), die mit dem Widerstand (R) und den Niederspannungstransistoren verbunden ist und zum Ein- und Ausschalten desjenigen der Niederspannungstransistoren (112, 113), der zu jeder gegebenen Zeit eingeschaltet ist, zum Regulieren des Stromes in der zugeordneten Last in Übereinstimmung mit dem Spannungsabfall an dem Widerstand dient.

7. System nach Anspruch 6, in dem die Einrichtung zum wahlweisen Einschalten der Niederspannungstransistoren ein so angeschlossener Flip-Flop-Schaltkreis (124) ist, daß er durch ein Signal an einem Eingangsanschluß (123) ausgelöst wird, und die Stromsteuereinrichtung einen mit dem Widerstand (R) verbundenen Schmitt-Trigger-Schaltkreis (129) und ein Paar von Gates (Gatter) (127, 128) aufweist, die mit dem Schmitt-Trigger-Schaltkreis und betreffenden Ausgängen des Flip-Flop-Schaltkreises verbunden sind, und die die betreffenden, Niederspannungstransistoren (113, 112) steuern.

**Revendications**

1. Système d'allumage par étincelles pour moteur à combustion interne, comprenant une pluralité de bobines d'allumage (10, 11) dans lesquelles la circulation du courant est établie et ensuite interrompue pour engendrer des étincelles, une pluralité de premiers transistors (12, 13) ayant des trajets collecteur-émetteur reliant une extrémité de l'une respective des bobines à un côté (14) d'une alimentation, les autres extrémités desdites bobines étant reliées à un point commun, un transistor haute tension (17) ayant son trajet collecteur-émetteur reliant ledit point commun à l'autre côté (18) de l'alimentation, une borne d'entrée (23) reliée à la base dudit transistor haute tension de sorte que les impulsions appliquées à ladite borne d'entrée rendent conducteur ledit transistor haute tension pour la durée de chacune de ces impulsions, et un circuit sélecteur (24) relié à ladite borne d'entrée et ayant une pluralité de sorties reliées aux bases des premiers transistors individuels respectifs (12, 13), ledit circuit sélecteur agissant pour rendre les premiers transistors conducteurs tour à tour pour des périodes commençant et se terminant avec l'arrivée des impulsions successives à la borne d'entrée, de sorte que l'interruption de la circulation du courant dans les bobines est effectuée en rendant la transistor haute tension conducteur à la fin de chaque impulsion.

2. Système suivant la revendication 1, comprenant en outre une pluralité de diodes (15, 16) reliant ladite autre extrémité desdites bobines individuelles respectives audit point commun.

3. Système la revendication 2, comprenant en outre une pluralité d'autres diodes (19, 20) reliant ladite première extrémité desdites bobines individuelles respectives à ladite autre borne (18).

4. Système suivant l'une ou l'autre des revendications 1, 2 ou 3 comprenant en outre une diode de Zener (21) reliant lesdits points communs à ladite autre borne (18).

5. Système suivant revendication 1 dans lequel lesdits moyens pour rendre sélectivement conducteurs lesdits transistors basse tension (12, 13) comprennent un circuit basculeur bistable (24) relié de façon à être déclenché un signal à une borne d'entrée (23) qui commande également ledit transistor haute tension (17).

6. Système suivant la revendication 3, comprenant en outre une résistance (R) en série avec ledit transistor haute tension (117), et des moyens (129) de commande du courant reliés à ladite résistance (R) et auxdits transistors basse tension (112, 113) et agissant pour rendre conducteur et non conducteur celui des transistors basse tension qui est conducteur à tout instant donné en concordance avec la tension aux bornes de ladite résistance pour régler le courant dans la charge associée.

7. Système suivant la revendication 6 dans lequel les moyens pour rendre sélectivement conducteurs les transistors basse tension sont constitués par un circuit basculeur bistable (124) relié de façon à être déclenché par un signal à une borne d'entrée (123), et lesdits moyens de commande de courant comprennent un circuit déclencheur de Schmitt (129) relié à ladite résistance (R) et une paire de portes (127, 128) reliées audit circuit déclencheur de Schmitt et aux sorties respectives du circuit basculeur bistable et commandant les transistors basse tension respectifs (112, 113).

FIG.1

FIG. 4.

FIG.2.

FIG.3.